# EUROPEAN PATENT APPLICATION

(11) **EP 3 456 982 A1**
(43) Date of publication of application: **20.03.2019**
(21) Application number: 18181491.4
(22) Date of filing: 03.07.2018
(51) Int. Cl.: F04D 29/58, F04D 17/16, F04D 25/06, F04D 29/42, H02K 11/33

(54) **BLOWER COMPRISING A HOLDER FOR RECEIVING AND COOLING ELECTRONIC COMPONENTS**

(30) Priority: 13.09.2017 JP 2017176205
(71) Applicant: Shinano Kenshi Co., Ltd., Ueda-shi, Nagano 386-0498 (JP)
(72) Inventor: FUKUZAWA, Akihito, Ueda-shi, Nagano 386-0498 (JP); ITO, Katsuya, Ueda-shi, Nagano 386-0498 (JP)
(74) Representative: Haseltine Lake LLP

(57) **Abstract**

A blower device includes: a motor; a fan rotated by the motor; a printed circuit board electrically connected to the motor; an electronic part electrically connected to the printed circuit board; a first case, the motor and the fan being positioned in one side with respect to the first case, the printed circuit board and the electronic part being positioned in another side with respect to the first case; a holder holding the electronic part such that the electronic part is spaced apart from the printed circuit board and is in thermal contact with the first case; and a second case fixed in the other side with respect to the first case and covering the printed circuit board, the electronic part, and the holder.

## Description

### [TECHNICAL FIELD]

The present invention relates to a blower device.

### [BACKGROUND ART]

Patent Document 1 discloses a device that cools a capacitor provided in a drive circuit for driving a motor by a fan connected to a rotational shaft of the motor.

### [PRIOR ART DOCUMENT]

### [PATENT DOCUMENT]

[Patent Document 1] Japanese Unexamined Patent Application Publication No. 2004-197714

### [SUMMARY OF THE INVENTION]

### [PROBLEMS TO BE SOLVED BY THE INVENTION]

In the above device, air is taken into a case from the outside through an air introduction hole formed in the case, and the capacitor in the case is cooled. For this reason, water or dust might enter the case from the outside through the air introduction hole, so that waterproofness and dustproofness might not be ensured.

It is therefore desirable to provide a blower device that ensures waterproofness and dustproofness while ensuring heat dissipation of an electronic part.

### [MEANS FOR SOLVING THE PROBLEMS]

An embodiment of the present invention provides a blower device including: a motor; a fan rotated by the motor; a printed circuit board electrically connected to the motor; an electronic part electrically connected to the printed circuit board; a first case, the motor and the fan being positioned in one side with respect to the first case, the printed circuit board and the electronic part being positioned in another side with respect to the first case; a holder holding the electronic part such that the electronic part is spaced apart from the printed circuit board and is in thermal contact with the first case; and a second case fixed in the other side with respect to the first case and covering the printed circuit board, the electronic part, and the holder.

### [EFFECTS OF THE INVENTION]

According to an embodiment of the present invention, it is possible to provide a blower device that ensures waterproofness and dustproofness while ensuring heat dissipation of an electronic part.

### [BRIEF DESCRIPTION OF THE DRAWINGS]

FIG. 1 is an external view of a blower device according to the present embodiment;
FIG. 2A is a cross-sectional view taken along line A-A of FIG. 1, and FIG. 2B is a partially enlarged view of FIG. 2A;
FIG. 3 is a cross-sectional view taken along line B-B of FIG. 1;
FIG. 4 is a cross-sectional view taken along line C-C of FIG. 1;
FIG. 5 is an external perspective view of a holder in a state of holding a capacitor;
FIG. 6 is an external perspective view of only the holder;
FIG. 7 is a partially enlarged view of the holder in the state of holding the capacitor; and
FIG. 8A is a simplified view of FIG. 1, and FIG. 8B is a simplified view of FIG. 3.

### [MODES FOR CARRYING OUT THE INVENTION]

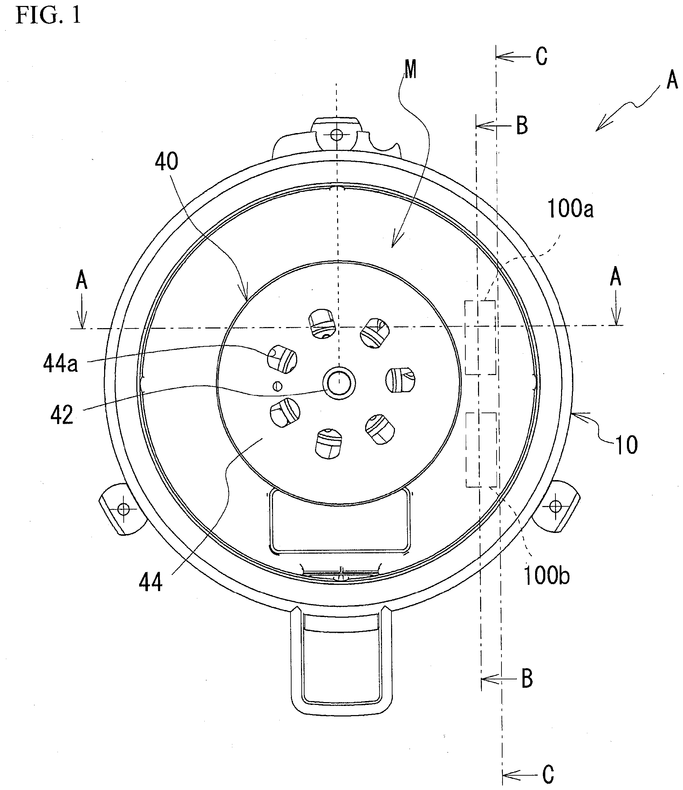

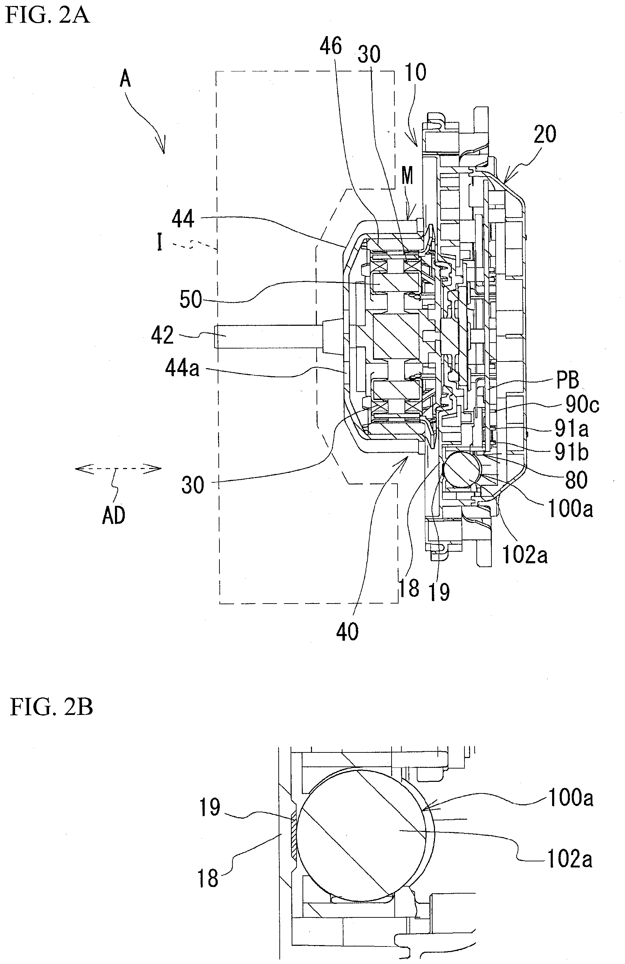

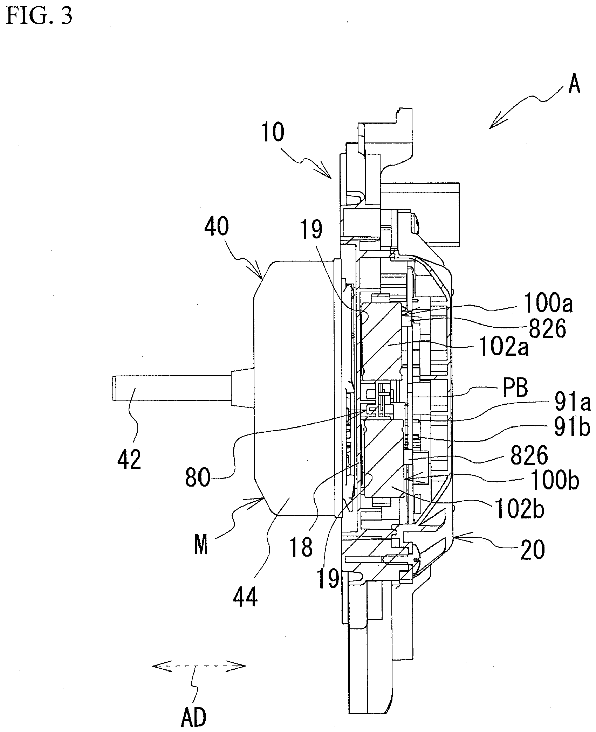

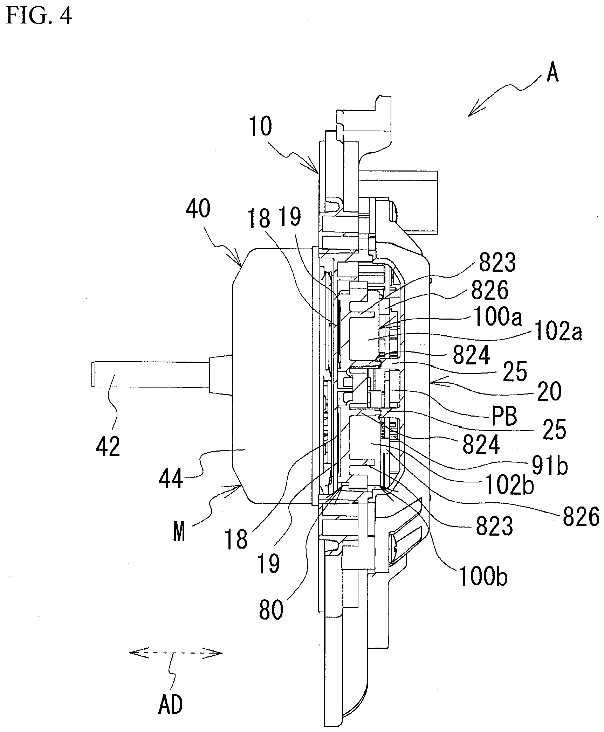

FIG. 1 is an external view of a blower device A according to the present embodiment. FIG. 2A is a cross-sectional view taken along line A-A of FIG. 1. FIG. 2B is a partially enlarged view of FIG. 2A. FIG. 3 is a cross-sectional view taken along line B-B of FIG. 1. FIG. 4 is a cross-sectional view taken along line C-C of FIG. 1. The blower device A includes cases 10 and 20, a motor M, a fan I rotated by the motor M, a printed circuit board PB electrically connected to the motor M, and the like. Additionally, the fan I is illustrated only in FIG. 2A and is omitted in the other drawings. The motor M and the fan I are positioned on one side of the case 10. A case 20 is attached to the other side of the case 10. The cases 10 and 20, each formed into a semi-casing shape, are assembled together to house the printed circuit board PB and capacitors 100a and 100b described later and electrically connected thereto. That is, the case 20 covers the printed circuit board PB and the capacitors 100a and 100b. The cases 10 and 20 are made of, but not limited to, a synthetic resin, and may be made of a metal. The cases 10 and 20 are examples of the first and second cases, respectively.

The motor M will be described. As illustrated in FIG. 2A, the motor M is positioned between the fan I and the case 10. The motor M includes coils 30, a rotor 40, a stator 50, and the like. The stator 50, made of a metal, has a shape so as to include an annular portion and teeth portions radially protruding outward from the annular portion. The coils 30 are wound around respective teeth portions of the stator 50. The coils 30 are electrically connected to the printed circuit board PB via terminals which are nonconductively supported by the stator 50. In addition to the capacitors 100a and 100b, parts for controlling the energization states of the coils 30 are mounted on the printed circuit board PB.

The rotor 40 includes a rotational shaft 42, a yoke 44, and one or more permanent magnets 46. The yoke 44, having a substantially cylindrical shape, is made of a metal. One or more permanent magnets 46 are fixed to an inner circumferential surface of the yoke 44. The yoke 44 is provided around the rotational shaft 42 with vent holes 44a for promoting heat dissipation of the motor M. The permanent magnets 46 face an outer side of the teeth portions of the stator 50. When the coils 30 are energized to excite the teeth portions of the stator 50, the magnetic attractive force and the magnetic repulsive force are exerted between the permanent magnets 46 and the teeth portions, whereby the yoke 44, that is, the rotor 40 rotates relative to the stator 50. In such a manner, the motor M is an outer rotor type motor in which the rotor 40 rotates.

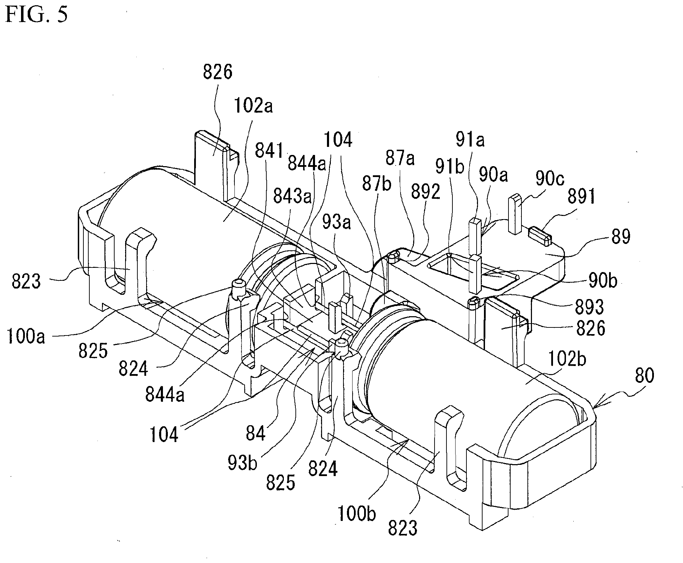

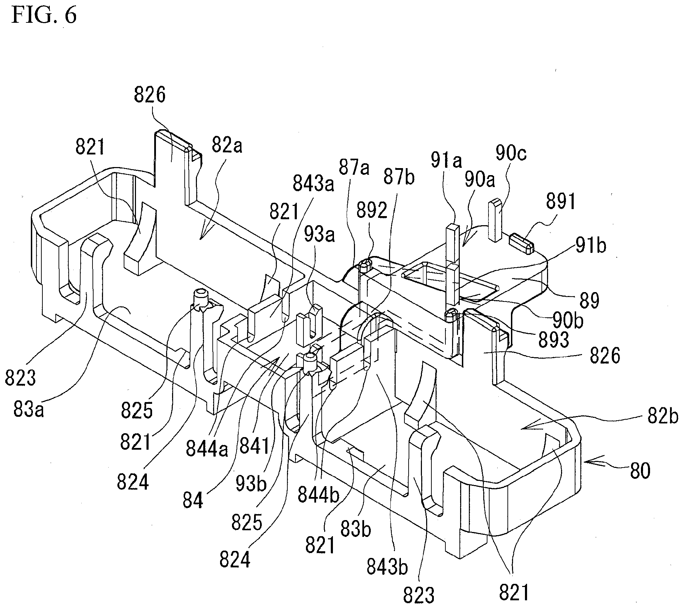

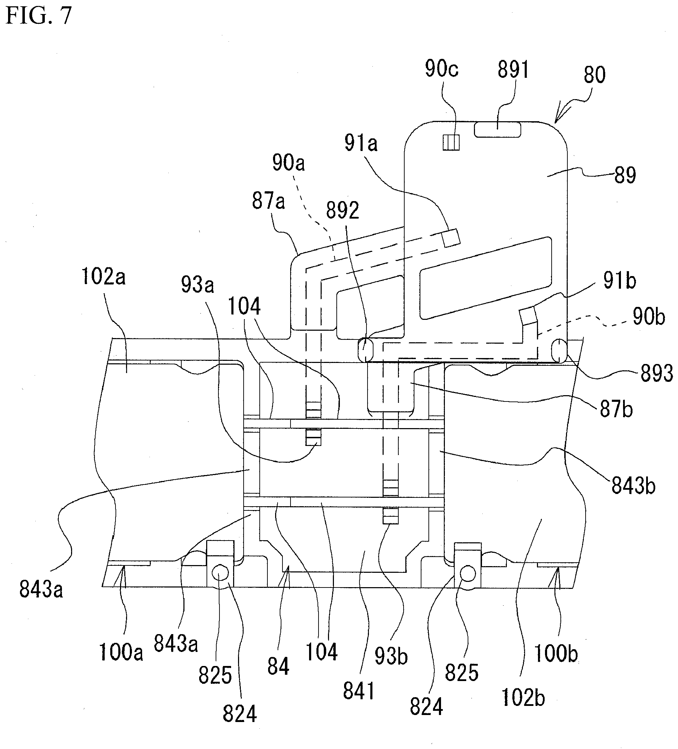

Next, a description will be given of the capacitors 100a and 100b and a holder 80 holding the capacitors 100a and 100b. FIG. 5 is an external perspective view of the holder 80 in a state of holding the capacitors 100a and 100b. FIG. 6 is an external perspective view of only the holder 80. FIG. 7 is a partially enlarged view of the holder 80 in the state of holding the capacitors 100a and 100b.

Firstly, the capacitors 100a and 100b will be described. As illustrated in FIGs. 3 to 5, the capacitors 100a and 100b respectively include main body portions 102a and 102b each having a substantially column shape. The holder 80 holds the capacitors 100a and 100b such that each longitudinal direction thereof is on the same line. Further, as illustrated in FIGs. 2A and 2B, the case 10 includes a wall portion 18 substantially perpendicular to the axial direction AD. Outer circumferential surfaces of the main body portions 102a and 102b face an inner surface of the wall portion 18. Specifically, the wall portion 18, positioned under projection of the fan I in the axial direction AD and radially outwardly from the yoke 44, faces the capacitors 100a and 100b. A heat transfer sheet 19 is interposed between the wall portion 18 and each of the main body portions 102a and 102b. Thus, the case 10 is in thermal contact with the main body portions 102a and 102b. The heat transfer sheet 19 is a member having good thermal conductivity, such as silicone, and efficiently transmitting the heat from the main body portions 102a and 102b to the case 10. Herein, as illustrated in FIG. 2A, an outer surface of the wall portion 18 faces the fan I. Thus, the rotating of the fan I allows air to flow along the outer surface of the wall portion 18. For this reason, the heat transmitted from the main body portions 102a and 102b to the wall portion 18 via the heat transfer sheet 19 is heat-exchanged with the air on the outer surface of the wall portion 18 by rotating the fan I. This ensures the heat dissipation properties of the capacitors 100a and 100b. Additionally, the wall portion 18 of the case 10 is provided in the vicinity of the heat transfer sheet 19 with projections for suppressing positional displacement thereof. The heat transfer sheet 19 is an example of a heat transfer member.

In the above example, the heat transfer sheet 19 is used as an example of a heat transfer member having good thermal conductivity, but the heat transfer member is not limited thereto. For example, it may be a metal plate having high thermal conductivity. In addition, the main body portions 102a and 102b and the wall portion 18 of the case 10 may be adhered to each other with an adhesive silicone. Further, the main body portions 102a and 102b may be in direct contact with the wall portion 18 of the case 10 without interposing a heat transfer member therebetween. As an example of an electronic part whose heat dissipation property is ensured by the wall portion 18 of the case 10, it is not limited to the capacitors 100a and 100b. The electronic part may be any that generates heat, for example, an FET, a choke coil, a shunt resistor, an IC chip, or the like.

The heat dissipation properties of the capacitors 100a and 100b are ensured by the wall portion 18 of the case 10 as described above. This eliminates the need for the heat dissipation properties of the capacitors 100a and 100b at the expense of airtightness in the cases 10 and 20. This ensures the heat dissipation properties of the capacitors 100a and 100b while ensuring airtightness, dustproofness, and waterproofness in the cases 10 and 20.

Next, the holder 80 will be described. As illustrated in FIGs. 5 and 6, the holder 80 includes holding portions 82a and 82b, a surrounding portion 84, and a support portion 89. Further, terminal pins 90a and 90b electrically connected to the capacitors 100a and 100b are buried in the holder 80. Specifically, the terminal pins 90a and 90b are formed integrally with the holder 80 by insert molding. Two terminals 104 are formed at each end portion of the main body portions 102a and 102b of the capacitors 100a and 100b. The capacitors 100a and 100b are held by the holder 80 such that the terminals 104 of the capacitors 100a and 100b face each other.

The holding portions 82a and 82b respectively hold both end portions of the main body portions 102a and 102b each having a substantially column shape. The holding portions 82a and 82b have respective frame shapes having openings 83a and 83b that partially expose the outer circumferential surfaces of the main body portions 102a and 102b, respectively. This ensures the heat dissipation properties of the main body portions 102a and 102b, and permits the inner surface of the wall portion 18 to be in thermal contact with parts of the outer circumferential surfaces of the main body portions 102a and 102b exposed from the openings 83a and 83b.

The holding portions 82a and 82b are provided at their inner wall surfaces with supporting surfaces 821 that are curved along the outer circumferential surface of the main body portion 102a or 102b and support the outer circumferential surface thereof. Further, the holding portion 82a is provided with engaging claw portions 823 and 824 for pressing the outer circumferential surface of the main body portion 102a against the supporting surfaces 821 by the elastic force, in order to prevent the main body portion 102a from dropping out. Similarly, the holding portion 82b is provided with other engaging claw portions 823 and 824. In assembling the capacitors 100a and 100b into the holder 80, the outer circumferential surfaces of the main body portions 102a and 102b are respectively inserted into the holding portions 82a and 82b against the elastic forces of the engaging claw portions 823 and 824. This facilitates the work of assembling the capacitors 100a and 100b into the holder 80.

As illustrated in FIG. 5, the engaging claw portion 824 is provided at its end with an engaging projection 825. As illustrated in FIG. 4, the engaging projection 825 is fitted into a boss portion 25 projecting from the inner surface of the case 20. Therefore, in a state where the capacitors 100a and 100b are in thermal contact with the wall portion 18 of the case 10 and the holder 80 is in contact with the case 20, the capacitors 100a and 100b and the holder 80 are sandwiched between the cases 10 and 20.

Also, each of the holding portions 82a and 82b is provided with a leg portion 826 that is in contact with an outer edge of the printed circuit board PB as illustrated in FIGs. 3 and 4. The leg portions 826 define the position of the printed circuit board PB relative to the holder 80, in other words, the positions of the capacitors 100a and 100b relative to the printed circuit board PB in the assembling work before the terminal pins 90a and 90b are fixed to the printed circuit board PB. As illustrated in FIGs. 3 and 4, the leg portions 826 extend in the direction perpendicular to the printed circuit board PB.

The surrounding portion 84 is positioned between the holding portions 82a and 82b. The surrounding portion 84 is formed into a semi-chasing shape surrounding the terminals 104 of the capacitors 100a and 100b. The surrounding portion 84 includes a low wall portion 841 and side wall portions 843a and 843b facing each other. The side wall portions 843a and 843b, facing the main body portions 102a and 102b, are provided with grooves 844a and 844b for positioning the terminals 104, respectively. The terminal pins 90a and 90b include ends 91a and 91b electrically connected to the printed circuit board PB and the other ends 93a and 93b electrically connected to the capacitors 100a and 100b, respectively, as will be described later in detail. The other ends 93a and 93b of the terminal pins 90a and 90b protrude from the low wall portion 841. Specifically, the other ends 93a and 93b are fitted through two respective holes formed in the low wall portion 841.

The other ends 93a and 93b of the terminal pins 90a and 90b are each formed into a bifurcated shape. The other end 93a, sandwiching one of the two terminals 104 of the main body portion 102a and one of the two terminals 104 of the main body portion 102b, is electrically conductively connected thereto. Likewise, the other end 93b, sandwiching the other of the two terminals 104 of the main body portion 102a and the other of the two terminals 104 of the main body portion 102b, is electrically conductively connected thereto. In assembling the capacitor 100a into the holder 80, the two terminals 104 of the capacitor 100a are inserted into the respective grooves 844a so as to be electrically conductively connected to the respective other ends 93a and 93b. The same is true in assembling the capacitor 100b into the holder 80. This improves workability of electrically conductive connection between the capacitors 100a and 100b and the terminal pins 90a and 90b.

The support portion 89 is positioned outside a line in which the holding portion 82a, the surrounding portion 84, and the holding portion 82b are aligned. The ends 91a and 91b of the terminal pins 90a and 90b protrude from the support portion 89. The ends 91a and 91b are fixed to the printed circuit board PB by soldering. In addition, like the terminal pins 90a and 90b, the support portion 89 is provided with a support pin 90c by insert molding. Also, the support pin 90c is fixed to the printed circuit board PB by soldering. However, the support pin 90c, not connected to any other electronic parts, is used for stably supporting the holder 80 on the printed circuit board PB.

The support portion 89 is provided on its surface facing the printed circuit board PB with protruding portions 891, 892, and 893. The projecting heights of the protruding portions 891 to 893 from the surface of the support portion 89 are substantially the same. The protruding portions 891 to 893, arranged in the form of a triangle, are in contact with the surface of the printed circuit board PB. This defines a clearance between the holder 80 and the surface of the printed circuit board PB. Covering portions 87a and 87b are provided around the support portion 89 so as to guide intermediate ports of the terminal pins 90a and 90b.

The terminal pins 90a and 90b support the holder 80 holding the capacitors 100a and 100b in the state where the ends 91a and 91b are fixed to the printed circuit board PB by soldering. Therefore, the number of parts is reduced, the production cost is reduced, and the weight is also reduced, as compared with, for example, a case of providing a member for stably supporting the holder 80 in addition to the terminal pins 90a and 90b.

In addition, the capacitors 100a and 100b and the holder 80 are sandwiched between the cases 10 and 20 as described above, which suppresses the holder 80 from rattling in the cases 10 and 20. This suppresses the application of a load to the joining portions of the ends 91a and 91b of the terminal pins 90a and 90b and the printed circuit board PB due to the rattling of the holder 80, which ensures the electrical conductivity between the terminal pins 90a and 90b and the printed circuit board PB.

Also, the holder 80 holds the capacitors 100a and 100b spaced apart from the printed circuit board PB and outside in the planar direction thereof as illustrated in FIG. 2A, which eliminate the need for mounting the capacitors 100a and 100b directly on the surface of the printed circuit board PB. This effectively uses a dead space around the printed circuit board PB.

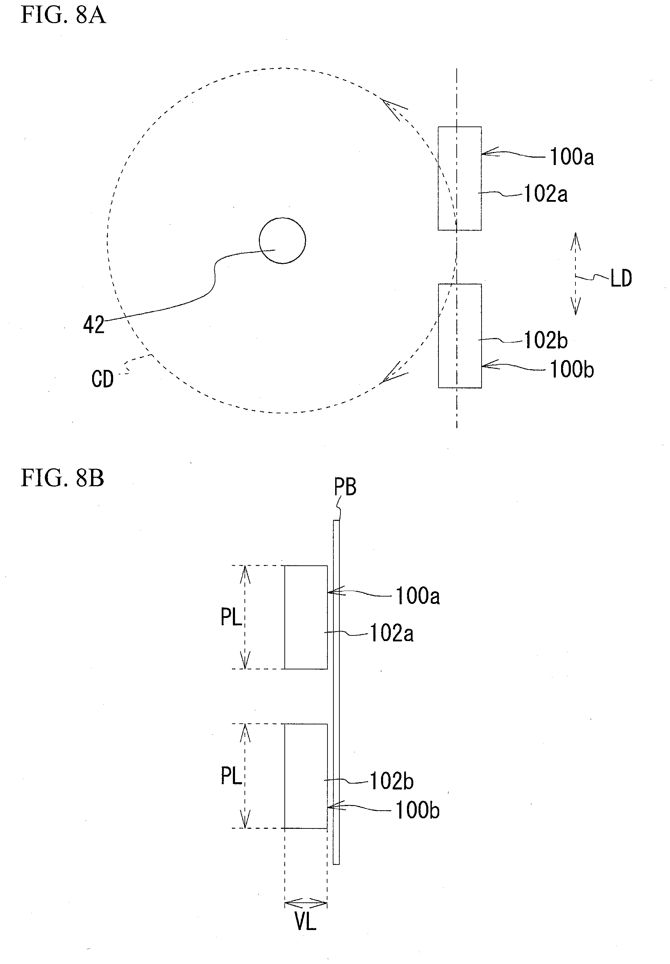

Next, the attitudes of the capacitors 100a and 100b held by the holder 80 will be described. FIG. 8A is a simplified view of FIG. 1. As illustrated in FIG. 8A, the capacitors 100a and 100b are held by the holder 80 such that the longitudinal direction LD of the capacitors 100a and 100b is along the circumferential direction CD about the rotational shaft 42 when viewed in the direction of the rotational shaft 42. In a case where, for example, the longitudinal direction LD of the capacitors 100a and 100b is the same as the radial direction of the rotational shaft 42, the entire size of the device might increase in the radial direction. However, the occurrence of the problem is suppressed in the present embodiment.

FIG. 8B is a simplified view of FIG. 3. Each length VL of the capacitors 100a and 100b perpendicular to the printed circuit board PB is smaller than each length PL of the capacitors 100a and 100b parallel to the printed circuit board PB. This suppresses an increase in the entire size of the device in the direction perpendicular to the printed circuit board PB, that is, in the axial direction AD.

While the exemplary embodiments of the present invention have been illustrated in detail, the present invention is not limited to the above-mentioned embodiments, and other embodiments, variations and modifications may be made without departing from the scope of the present invention.

In the above embodiment, the holder 80 holds the two capacitors 100a and 100b, but is not limited thereto. The holder 80 may hold one or three or more electronic parts. In the above embodiment, the two terminal pins 90a and 90b support the holder 80, but embodiments of the present invention are not limited thereto. For example, only one of the terminal pins 90a and 90b may support the holder 80. In the above embodiment, the motor M is the outer rotor type, but is not limited thereto. The motor may be an inner rotor type. In the above embodiment, the terminal pins 90a and 90b are integrally formed with the holder 80 by insert molding, but are not limited thereto. For example, at least one of the terminal pins 90a and 90b may be molded separately from the holder 80, and may be assembled into the holder 80 thereafter.

## Claims

1. A blower device comprising:
a motor;
a fan rotated by the motor;
a printed circuit board electrically connected to the motor;
an electronic part electrically connected to the printed circuit board;
a first case, the motor and the fan being positioned in one side with respect to the first case, the printed circuit board and the electronic part being positioned in another side with respect to the first case;
a holder holding the electronic part such that the electronic part is spaced apart from the printed circuit board and is in thermal contact with the first case; and
a second case fixed in the other side with respect to the first case and covering the printed circuit board, the electronic part, and the holder.

2. The blower device of claim 1, further comprising a terminal pin electrically connected to the electronic part and the printed circuit board, fixed to the printed circuit board, and assembled into the holder so as to support the holder.

3. The blower device of claim 1 or 2, further comprising a heat transfer member interposed between the first case and the electronic part and transmitting heat from the electronic part to the first case.

4. The blower device of any one of claims 1 to 3, wherein
the electronic part is in thermal contact with the first case,
the holder is in contact with the second case, and
the electronic part and the holder are sandwiched by the first and second cases.

5. The blower device of any one of claims 1 to 4, wherein the holder includes an engaging claw portion holding the electronic part by an elastic force.

6. The blower device of any one of claims 1 to 5, wherein the holder holds the electronic part such that a longitudinal direction of the electronic part is along a circumferential direction about an axis of the motor when viewed in a direction of the axis of the motor.

7. The blower device of any one of claims 1 to 6, wherein the holder holds the electronic part such that a length of the electronic part in a direction perpendicular to the printed circuit board is equal to or less than a length of the electronic part in a direction parallel to the printed circuit board.

8. The blower device of any one of claims 1 to 7, wherein the holder holds the electronic part such that the electronic part is positioned outside the printed circuit board in a planar direction of the printed circuit board.

9. The blower device of any one of claims 1 to 8, wherein the electronic part is a capacitor.
